# EUROPÄISCHE PATENTANMELDUNG

(11) **EP 1 255 120 A2**
(43) Veröffentlichungstag der Anmeldung: **06.11.2002**
(21) Anmeldenummer: 02100426.2
(22) Anmeldetag: 30.04.2002
(51) Int. Cl.: G01R 33/34

(54) **MR-Gerät mit einem offenen Magnetsystem und einer Quadratur-Spulenanordnung**

(30) Priorität: 02.05.2001 DE 10121449
(71) Anmelder: Philips Corporate Intellectual Property GmbH, 20099 Hamburg (DE); Koninklijke Philips Electronics N.V., 5621 BA Eindhoven (NL)
(72) Erfinder: Schulz, Volkmar, c/o Philips Corp. Int. Prop. GmbH, 52066, Aachen (DE); Findeklee, Christian, Philips Corp. Int. Prop.GmbH, 52066, Aachen (DE); Leussler, Christoph, Philips Corp. Int. Prop.GmbH, 52066, Aachen (DE)
(74) Vertreter: Volmer, Georg, Dipl.-Ing.

(57) **Zusammenfassung**

Die Erfindung betrifft ein MR-Gerät mit einem offenen Magnetsystem und mit einer Quadratur-Spulenanordnung, die auf mindestens einer der beiden in Richtung des stationären Magnetfeldes gegeneinander versetzten Seiten des Untersuchungsbereichs einen durch Abstimmkondensatoren abgestimmten Resonator enthält, der zwei großflächige im Abstand voneinander befindliche elektrische Leiter umfasst, die an einer Anzahl von über den Umfang verteilten Verbindungspunkten miteinander verbunden sind, und der mit wenigstens zwei auf dem Umfang verteilten Anschlüssen zum Empfangen oder Erzeugen von in der Phase gegeneinander versetzten Hochfrequenzmagnetfeldern versehen ist. Außerdem betrifft die Erfindung eine entsprechende Quadratur-Spulenanordnung

## Beschreibung

Textbeginn Die Erfindung betrifft ein MR-Gerät (MR = Magnetresonanz) mit einem offenen Magnetsystem zur Erzeugung eines homogenen stationären Magnetfeldes in einem Untersuchungsbereich und mit einer Quadratur-Spulenanordnung zum Erzeugen oder zum Detektieren von Hochfrequenz-Magnetfeldern im Untersuchungsbereich. Als "offenes" Magnetsystem wird dabei ein Magnetsystem bezeichnet, das ein ― in der Regel vertikales ― Magnetfeld zwischen zwei Polplatten eines Permanentmagneten oder zwischen zwei Spulenpaketen eines Elektromagneten erzeugt. Der Untersuchungsbereich ist dabei weitgehend offen ― im Gegensatz zu den Verhältnissen bei einem "geschlossenen" Magnetsystem, der den Untersuchungsbereich zylinderförmig umschließt. Außerdem bezieht sich die Erfindung auf eine einer Quadratur-Spulenanordnung für ein solches Magnetsystem.

Aus der DE PS 4 232 884 ist bereits ein MR-Gerät mit einem offenen Magnetsystemen und einer Spulenanordnung zum Empfangen oder Erzeugen von Hochfrequenzmagnetfeldern bekannt. Die Spulenanordnung besteht aus zwei gleichartigen, in Richtung des Hauptmagnetfeldes gsgeneinander versetzten und beiderseits des Untersuchungsbereichs befindlichen, durch Abstimmkapazitäten abgsstimmten Resonatoren. Jeder Resonator umfasst einen großflächigen Leiter, der zugleich als Hochfrequenzschirm dient, und eine Leiterstruktur, die eine Anzahl von in derselben Ebene befindlichen und in Abstand voneinander angsordneten streifenförmigen Leitern umfasst.

Mit einer derartigen Leiterstruktur kann im Untersuchungsbereich lediglich ein linear polarisiertes Hochfrequenzmagnetfeld erzeugt bzw. empfangen werden. Es ist jedoch auch möglich, jeden Resonator durch eine zweite, gegenüber der ersten um 90° verdrehte, Leitelstruktur zu einer Quadratur-Spulenanordnung zu ergänzen, die ein zirkular polarisiertes Feld erzeugt. Die beiden Leiterstrukturen müssen dabei sehr eng beieinander liegen, wodurch elektrische Felder und daher unerwünschte kapazitive Kopplungen zwischen den Leiterstrukturen entstehen, die durch eine oder mehrere Induktivitäten wieder kompensiert werden müssen.

Aufgabe der vorliegenden Erfindung ist es, ein MR-Gerät mit einer verbesserten Quadratur-Spulenanordnung zu schaffen. Diese Aufgabe wird erfindungsgemäß gelöst durch ein MR-Gerät mit einem offenen Magnetsystem zur Erzeugung eines homogsnen stationären Magnetfeldes in einem Untersuchungsbereich und mit einer Quadraturspulenanordnung die auf mindestens einer der beiden in Richtung des stationären Magnetfeldes versetzten Seiten des Untersuchungsbereichs einen durch Abstimmkapazitäten abgestimmten Resonator mit folgenden Merkmalen enthält:
- der Resonator umfaßt auf seiner dem Untersuchungbereich zugewandten Seite einen ersten, großflächigen Leiter und auf seiner vom Untersuchungbereich abgswandten Seite einen zweiten im Abstand von dem ersten befindlichen zweiten Leiter,
- die beiden Leiter sind - zumindest bei der Frequenz, bei der der Resonator in Resonanz ist - elektrisch miteinander verbunden
- der Resonator ist mit wenigstens zwei auf dem Umfang verteilten Anschlüssen zum Empfangen oder Erzeugen von in der Phase gegeneinander versetzten Hochfrequenzmagnetfeldern versehen.

Für beide Polarisationsrichtungen ist also ein ganeinsamer großflächiger Leiter vorgesehen ― und nicht zwei aus streifenförmigen Leitern bestehende Leiterstrukturen, so dass sich ein wesentlich einfacherer Aufbau ergibt als bei dem bekannten MR-Gerät. Als "großflächig" wird ein in zwei Dimensionen ausgedehnter Leiter bezeichnet, der eine zusammenhängende und durchgehende (nicht unterbrochene) Form aufweist, bzw. ― wenn er keine durchgehende Form hat ― sich bei Hochfrequenz praktisch wie ein durchgehender Leiter verhält.

Bedingt durch den großflächigen Leiter hat der Resonator eine geringere Induktivität, woraus sich eine höhere Empfindlichkeit der Quadratur-Spulenanordnung ergibt (d.h., dass ein bestimmtes Magnetfeld im Untersuchungsbereich mit geringeren Strömen erzeugt werden kann bzw. dass ein Kernmagnetisierungszerfall im Untersuchungsbeteich ein höheres MR-Signal an den Anschlüssen induziert), als bei der bekannten Anordnung.

Die geringste Induktivität des Resonators erzwingt, dass die Abstimmkapazitäten größer sein müssen, damit der Resonator bei einer bestimmten Frequenz schwingt. Die höhere Kapazität hat zur Folge, dass die an den Abstimmkapazitäten maximal auftretende Spannung kleiner ist als bei der bekannten Anordnung, was beim Betrieb der Quadratur-Spulenanordnung als Sendespule für die Patientensicherheit einen zusätzlichen Vorteil darstellt. Weiterhin ergibt sich bei der Erfindung im Untersuchungsbereich auch in der Nähe der großflächigen Leiter ein zu deren Oberfläche paralleler Verlauf des Hochfrequenzmagnetfeldes, während bei der bekannten Anordnung in diesem Bereich die einzelnen Leiter die Homogenität des Hochfrequenzmagnetfeldes beeinträchtigen.

Im Prinzip kann man mit einem einzigen Resonator im Untersuchungsbereich ein räumlich hinreichend homogenes Hochfrequenzmagnetfeld erzeugen, insbesondere wenn der Resonator große Abmessungen hat und die Abmessungen des Untersuchungsbereichs in Richtung senkrecht zum Resonator vergleichsweise klein sind Durch die Verwendung von zwei auf gsgenüberliegenden Seiten befindlichen Resonatoren lässt sich jedoch ― ebenso wie bei dem bekannten MR-Gerät ― eine bessere räumliche Homogenität erreichen.

In den Ansprüchen 2 und 3 sind alternative Ausführungsformen der Erfindung beschrieben. Die Ausführungsform nach Anspruch 2 hat eine höhere Empfindlichkeit (d.h. derselbe Strom erzeugt bei sonst gleichen Parametern ein stärkeres Hochfrequenzmagnetfeld) und geringere Verluste als die Ausführungsform nach Anspruch 3, deren Vorteil darin besteht, dass der Hochfrequenzschirm und der erste Leiter voneinander entkoppelt sind.

Bei der bevorzugten Ausgsstaltung nach Anspruch 4 kann die Erzeugung eines zirkular polarisierten Hochfrequenzmagnetfeldes im Untersuchungsbereich allein schon durch Form des ersten Leiters und die räumliche Anordnung der Verbindungspunkte und der Anschlüsse erreicht werden. Wenn das Feld in der Umgabung des Resonators aber beispielsweise durch an gegenüberliegenden Seiten des Resonators befindliche Bauteile (z B. Stützen) verzerrt wird, kann der Resonator auch eine abweichende Form haben, zB. eine schwach elliptische. Wesentlich ist, dass in einer zur Richtung des stationären Feldes senkrechten Ebene des Untersuchungsbereich das mit der Quadratur-Spulenanordnung erzeugbare Hochfrequenzmagnetfeld seinen räumlichen Verlauf beibehält, wenn man die Quadratur-Spulenanordnung um eine zentrale Achse um einen bestimmten Winkel (z B 90°) dreht.

Anspruch 5 beschreibt eine mögliche Anordnung der Abstimmkapazitäten. Die Abstimmkapazitäten sind hierbei nicht ― wie bei dem bekannten MR-Gerät ― für nur eine der beiden (zueinander senkrechten Polarisationsrichtungen) vorgesehen, sondern in der Regel für beide. Eine Realisierung der Resonatoren in dieser Weise ist daher weniger aufwendig. Alle Abstimmkapazitäten können die gleiche Kapazität haben. Sie können aber auch eine unterschiedliche Kapazität besitzen, wenn gewährleistet ist, dass sich bezüglich der Anschlüsse dieselbe räumliche und elektrische Konfiguration ergibt.

Statt die Abstimmkapazitäten durch diskrete, an den Verbindungspunkten befindliche Abstimmkondensatoren zu realisieren, kann gemäß Anspruch 6 zwischen den beiden Leitern ein geeignetes (insbesondere verlustarmes) dielektrisches Material vorgesehen sein, das mit den Leitern verteilte (Abstimm-) Kapazitäten bildet. Das dielektrische Material (mit einer relativen Dielektrizitätskonstanten εᵣ zwischen 60 und 80) kann segmentförmig sein. Es kann aber auch ein zusammenhängender Bereich zwischen den Leitern mit einem dielektrischen Material gefüllt sein, beispielweise in Form eines Ringes oder einer runden oder anders geformten Scheibe oder Folie. Eine Abstimmung kann dabei durch Bohrungen im Dielektrikum erfolgen, und der Feldverlauf kann durch

eine geeignete Formgebung des Dielektrikums beeinflußt werden. Die Erwärmung des Patienten durch das Hochfrequenzfeld ist gering

Bei der Anordnung nach Anspruch 5 können sich an den Abstimmkapazitäten im Sendebetrieb (wenn die Quadratur-Spulenanordnung zur Erzeugung von Hochfrequenzmagnetfeldern genutzt wird) Spannungen von einigen kV und dementsprechend hohe elektrische Feldstärken in der Nähe der Kondensatoren ergeben. Wenn der Patient in die Nähe der Abstimmkapazitäten kommt, kann sich sein Gewebe durch das (elektrische) Hochfrequenzfeld in unerwünschter Weise erwärmen. Diese Erwärmung lässt sich bei der Ausgestaltung nach Anspruch 7 vermeiden, weil die beiden Leiter des Resonators an den Verbindungspunkten leitend miteinander verbunden sind. Die Abstimmkapazitäten befinden sich dabei in einem Bereich, dem der Patient in der Regel nicht nahe kommen kann.

Die Verhältnisse sind hinsichtlich der Hochfrequenzmagnetfelder optimal, wenn die Leiter durch eine durchgehende, vorzugsweise ebene Platte bzw. Schicht gebildet werden. Allerdings werden in diesen Leitern bei einer MR-Untersuchung durch das niederlrequente Schalten von magnetischen Gradientenfeldern Wirbelströme induziert, die einerseits eine Erwärmung der Leiter zur Folge haben und andererseits auf das Gradientensystem zurückwirken und den zeitlichen und räumlichen Verlauf der erzeugten Gradientenfelder beeinflussen können.

Dieser unerwünschte Einfluss lässt sich durch die Ausgsstaltung nach Anspruch 8 verringern. Die Schlitze sollten dabei relativ zu den Anschlüssen so verlaufen, dass die Symmetrie gewahrt bleibt, und die Überbrückungskondensatoren, deren Kapazität wesentlich größer ist als die der Abstimmkapazitäten, sollten so bemessen sein, dass sie für die Wirbelströme eine hohe Impedanz darstellen, bei der Resonanzfrequenz des Resonators jedoch praktisch einen Kurzschluss darstellen. Die Wirkung dieser Maßnahme beruht darauf, dass für den Frequenzbereich der Gradientensequenzen der geschlitzte Leiter in eine Anzahl kleinerer Bereiche unterteilt wird, in denen deutlich verringerte Wirbelströme hervorgsrufen worden, während er für die Hochfrequenzströme nach wie vor eine einzige große leitende Fläche bildet.

Die Wirbelströme werden um so besser unterdrückt, je kleiner die durch die Schlitze entstehenden Leiterbereiche sind. Je mehr Schlitze aber vorhanden sind, um so mehr Überbrückungskondensatoren muss ein Hochfrequenzstrom durchfließen. Da die Überbrückungskondensatoren verlustbehaftet sind, vergrößern sich dadurch die Verluste im Resonator wodurch sich die Güte des Resonators verringert.

Insofern günstiger ist die Ausgsstaltung nach Anspruch 9, weil die leitenden Flächen dabei in so schmale Streifen unterteilt werden können, dass eine einmalige Unterbrechung eines jeden Streifens durch einen Schlitz ausreicht, um eine erhöhte Ausprägung von Wirbelströmen zu vermeiden. Lässt man einen Strom in Streifenrichtung von der einen Seite zur anderen fließen, dann muss dieser nur einmal über einen Überbrückungskondensator fließen. Für die Erzeugung eines Quadraturfeldes ist es dann erforderlich, die zweite mit dem gleichen Schlitzmuster versehene leitende Fläche vorzusehen und die beiden Schlitzmuster um 90° gegeneinander zu verdrehen. Die leitenden Flächen sind dabei an ihren Außenrändern miteinander verbunden, so dass sie nach außen hin wie ein einziger, großflächiger und durchgehender Leiter wirken. Es ist auch möglich, mehr als zwei leitende Flächen auf diese Weise miteinander zu verbinden, zB. vier.

Am einfachsten lassen sich die beiden leitenden Flächen dabei gemäß Anspruch 10 realisieren.

Wenn beiderseits des Untersuchungsbereichs je ein Resonator vorgesehen ist, sind die beiden Resonatoren dominant induktiv gekoppelt, wodurch in Verbindung mit der hohen Güte der Resonatoren die beiden gekoppelten Resonatoren nicht mehr auf der Frequenz schwingen, auf die sie abgestimmt sind, sondern auf zwei Frequenzen beiderseits dieser Resonanzfrequenz. Dies lässt sich durch die Ausgestaltung nach Anspruch 11 vermeiden. Die Verbindung über die λ/2-Leitung bewirkt, dass die beiden Resonatoren bei der Resonanzfrequenz parallel gsschaltet werden, so dass es in der Umgebung der Larmor-Frequenz nur noch eine gemeinsame Resonanzfrequenz gibt. Die Parallelschaltung hat weiterhin den Vorteil, dass die Güte der Resonatoren beim Einführen eines Patienten in das MR-Gerät in gleichem Maße abnimmt. Wäre die Leitung nicht vorhanden, würde in der Regel die Güte des unteren Resonators stärker abnehmen als die Güte des oberen Resonators, weil der Patient zu dem unteren Resonator meist einen geringeren Abstand hat als zum oberen Resonator. Diese ungleichmäßige Veränderung der Güte hätte zur Folge, dass das von den beiden Resonatoren erzeugte Hochfrequenzmagnetfeld inhomogener würde. (Anstatt einer λ/2-Leitung kann natürlich auch eine gekreuzte λ-Leitung oder allgemein eine nλ/2-Leitung verwendet werden, wobei n eine ganze Zahl ist.)

Wenn die Leiter der Resonatoren mit Schlitzen versehen sind, kann das Hochfrequenzmagnetfeld nicht nur den Bereich zwischen den beiden Leitern und den Untersuchungsbereich durchsetzen, sondern auch einen außerhalb liegenden Bereich, in dem sich beispielsweise Gradientenspulen befinden können. Dadurch wird ein Teil der Energie der Quadratur-Spulenanordnung in die Gradienten-Spulenanordnung eingekoppelt, wodurch sich die Güte der Resonatoren drastisch vermindert. Dies lässt sich durch die in Anspruch 12 angegebene Ausgestaltung vermeiden.
Anspruch 13 beschreibt eine Quadratur-Spulenanordnung gemäß der Erfindung.

Die Erfindung wird nachstehend anhand der Zeichnungen näher erläutert. Es zeigen:
Fig 1 ein MR-Gerät mit der erfindungsgemäßen Quadratur-Spulenanordnung
Fig. 2 eine erste Ausrührungsform eines Resonators der Quadratur-Spulenanordnung,
Fig 3 eine Variante dieser Ausführungsform,
Fig 4 eine Draufsicht auf einen solchen Resonator mit den vorhandenen Anschlüssen,
Fig 5 eine zweite Ausführungsform,
Fig 6 eine Draufsicht auf eine dritten Ausführungsform der Erfindung,
Fig 7 eine Draufsicht auf einen der beiden Leiter bei einer vierten Ausführungsform und
Fig 8 eine Seitenansicht dieses Leiters.

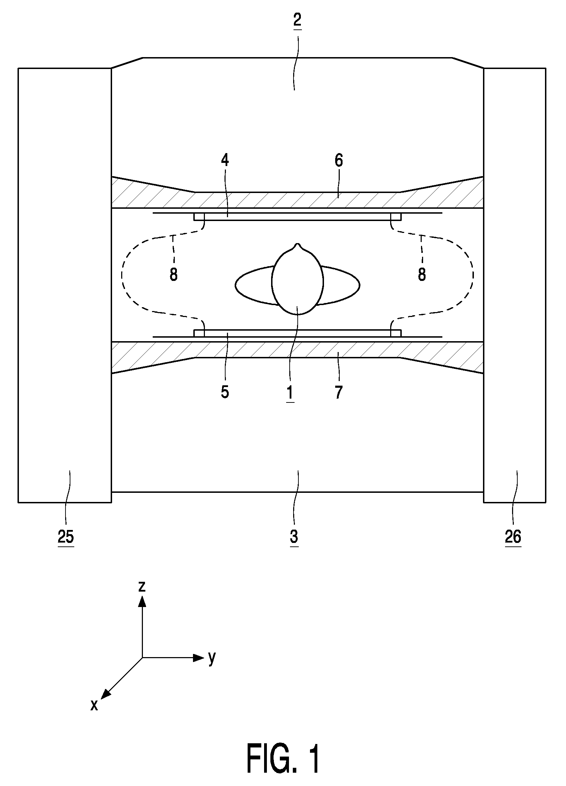

Fig 1 zeigt ein MR-Gerät mit einem Magnetsystem zur Erzeugung eines homogenen stationären Magnetfeldes, das in einem durch einen Patienten 1 symbolisierten Untersuchungsbereich vertikal verläuft, d. h. in z-Richtung des in Fig. 1 dargestellten xyz-Koordinatensystems. Das Magnetsystem kann durch ein Permanentmagnet-System gebildet werden; in diesem Fall stellen die Teile 2 und 3 die Pole eines solchen Permanentmagneten dar, die über ein nicht dargsstelltes Joch miteinander verbunden sind. Es kann sich aber um ein ― vorzugsweise supraleitendes ― Magnetsystem mit Spulenpaketen 2 und 3 handeln. Die Larmor-Frequenz, mit der die im Untersuchungsbereich angsregte Kernmagnetisierung präzediert, ist der Stärke des stationären Magnetfeldes proportional. Die Larmor-Frequenz von Protonen beträgt etwa 42.6 MHz, wenn die magnetische Flussdichte des stationären Magnetfeldes 1 Tesla beträgt.

Die beiden Teile 2 und 3 des Magnetsystems sind über seitlich vom Untersuchungsbereich 1 befindliche Säulen 25, 26 miteinander verbunden. An der dem Untersuchungsbereich zugewandeten Seite des Magnetsystems 2, 3 befinden sich Gradienten-Spulensysteme 6, 7, die ein zeitliches variierendes Magnetfeld, mit einem annährend linearen Gradienten der z-Komponente in x-, y- oder z-Richtung erzeugen können. In unmittelbarer Nähe der beiden Gradienten-Spulensystem 6, 7 befindet sich je ein Resonator 4, 5, der bei der Larmor-Frequenz in Resonanz ist. Die beiden Resonatoren sind Teile einer Quadraturspulenanordnung, mit der im Untersuchungsbereich ein zur z-Richtung senkrechtes, zirkular polarisiertes Hochfrequenzmagnetfeld mit der Larmor-Frequenz erzeugt werden kann bzw. mit der MR-Signale (mit der Larmor-Frequenz) aus dem Untersuchungsbereich 1 empfangen werden können. Die spiegelbildlich zum Untersuchungsbereich angeordneten Resonatoren sind sinnvoller weise identisch aufgebaut, so dass im folgenden zur Erläuterung nur ein Resonator beschrieben wird.

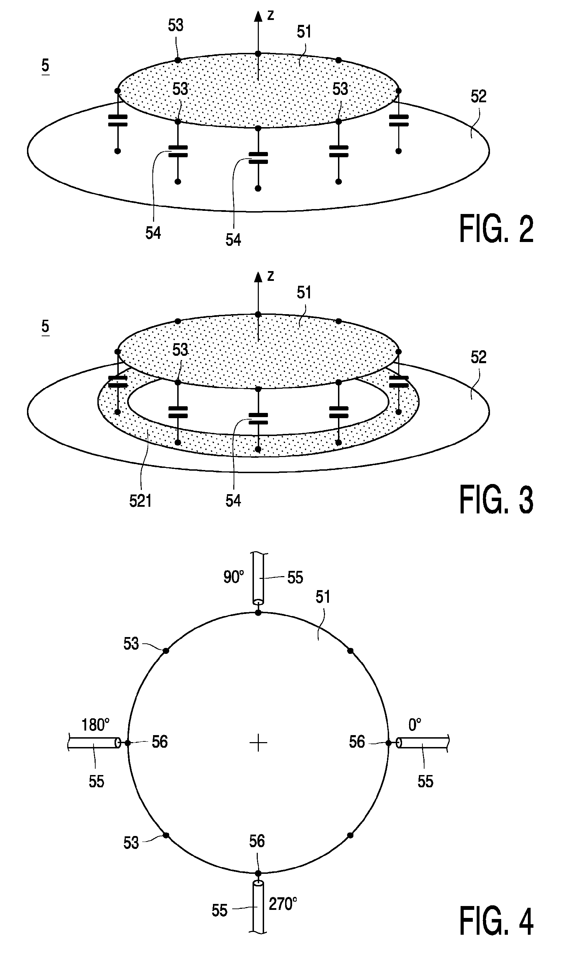

Fig 2 zeigt den Resonator 5 in perspektivischer Darstellung. Der Resonator umfasst zwei parallele, mit einem Abstand von ca. 2 bis 3 cm angeordnete, kreisförmigs und zueinander konzentrische ebene Leiter 51 und 52. Der dem Untersuchungsbereich zugswandte Leiter 51 hat einen Durchmesser in der von etwa 50 bis 60 cm und ist deutlich kleiner als der Leiter 52. Dadurch wird erreicht, dass sich die Feldlinien des zwischen den Leitern 51 und 52 erzeugten Hochfrequenzmagnetfeldes im wesentlichen über den Untersuchungsbereich 1 schließen. Der Leiter 52 ist dabei gleichzeitig als Hochfrequenzschirm wirksam.

An einer Anzahl von gleichmäßig über den äußeren Umfang des Leiters 51 verteilten Verbindungspunkten 53 sind die beiden Leiter 51 und 52 über Abstimmkapazitäten in Form von diskreten Abstimmkondensatoren 54 miteinander verbunden. Die Zahl der Kondensatoren bestimmt die Zahl der quasistatischen Schwingungsmoden des Resonators, von denen jedoch nur der bei der niedrigsten Frequenz auftretende Schwingungsmodus ausgenutzt wird Die Kapazitäten der Kondensatoren sind so bemessen, dass der Resonator bei der Larmor-Frequenz in diesem Schwingungsmodus in Resonanz ist.

Die Zahl der Verbindungspunkte und die Kapazitäten der Abstimmkondensatoren sind so gewählt, dass sich eine Symmetrie bezüglich zweier um 90° gegeneinander versetzter Achsen bzw. eine Winkelsymmetrie ergibt, d. h. dass die Anordnung nach einer Drehung um 90° denselben Anblick bietet. Dafür muss die Zahl der Verbindungspunkte 53 bzw. der Kondensatoren 54 durch vier (ohne Rest) teilbar sein. Im Ausführungsbeispiel beträgt diese Zahl acht, doch ist es günstiger, eine größere Anzahl zu verwenden, z B. 24 oder 32, um eine gleichmäßigere Stromverteilung im Leiter 51 und damit eine größere Homogenität des erzeugten Magnetfeldes zu erreichen.

Wie in Fig. 4 dargestellt, wird an vier gleichmäßig auf dem Umfang des Leiters 51 verteilten Anschlüssen 56 über je ein Koaxialkabel 55 ein Wechselstrom mit der Larmor-Frequenz eingespeist, wobei die Phasenlags 0° ― 90° ― 180° und 270° beträgt. Der Strom fließt von einem Anschluss 56 zu dem diametral gegenüberliegenden Anschluss 56 sowie über die Verbindungspunkte 53 ― aber nicht über die um 90° räumlich versetzten Anschlüsse, da die um 90° gegeneinander räumlich versetzten Anschlüsse voneinander elektrisch entkoppelt sind

Es ist nicht erforderlich, dass vier Anschlüsse 56 vorgesehen sind; es genügt wenn die Hochfrequenzvwchselströme an zwei räumlich um 90° gegeneinander versetzten Punkten eingsspeist werden. Allerdings ergibt sich bei vier Anschlusspunkten ein symmetrischeres Feld bei Belastung. Es könnten aber zB. auch drei gleichmäßig auf dem Umfang verteilte Anschlüsse vorgesehen sein, wenn dort jeweils um 120° gegeneinander versetzte Ströme eingsspeist würden.

Es ist auch nicht erforderlich, dass die Abstimmkondensatoren identische Kapazitäten haben. Die Kapazitäten an den zwischen den Anschlüssen 56 liegenden Verbindungspunkten können größer sein als die Kapazitäten an den mit den Anschlüssen 56 zusammenfallenden Verbindungspunkten ― so lange die erwähnte Symmetrie erhalten bleibt, d. h. so lange sich die Anordnung von den Anschlüssen 56 aus betrachtet geometrisch und elektrisch nicht unterscheidet. Wenn die zwischenliegenden Kapazitäten größer sind, ergibt sich eine homogeneres Magnetfeld Es ist auch nicht erforderlich ― obwohl zweckmäßig―, dass die Anschlüsse 56 mit Verbindungspunkten 53 zusammenfallen. Die Anschlüssen können auch an anderen Punkten des Leiters 51 liegen, so lange die erwähnte Symmetrie der Anschlüsse gewahrt bleibt.

Weiterhin ist es nicht erforderlich, dass die Leiter 51, 52 die Form eines Kreises haben. Diese Leiter können ― unter Beachtung der erwähnten Symmetriebedingung ― auch vieroder achteckig geformt sein. Wenn das Hochfrequenzmagnetfeld im Untersuchungsbereich durch äußere Komponenten des System verzerrt werden sollte - beispielsweise durch die Stützen 25, 26 ―, ließe sich dies zB. durch eine schwach elliptische Form beseitigen. Wichtig bei dieser Gestaltung ― wie bei allen anderen ― ist, dass im Untersuchungsbereich ― vorzugsweise in seiner zentralen Ebene - ein symmetrischer, homogener Feldverlauf erreicht wird.

Der obere Resonator 4 wird analog zu Fig 4 betrieben, jedoch so, dass die übereinander liegenden Anschlüsse beider Resonatoren 4 und 5 gegenphasig gespeist werden. Dadurch stimmt die Richtung der von den beiden Resonatoren erzeugten Hochfrequenzmagnetfelder in jedem Augsnblick überein. Zwischen diesen beiden Resonatoren besteht jedoch eine induktive Kopplung die dazu führt, dass die Impedanz dieser Resonatoren nicht bei der Frequenz ein Maximum hat, auf die sie abgestimmt sind, sondern bei zwei Frequenzen beiderseits dieser Frequenz

Dieser unerwünschte Effekt wird dadurch beseitigt, dass die beiden Resonatoren an übereinander liegenden Punkten durch ― in Fig. 1 gestrichelt angedeutete― λ/2-Leitungen 8 miteinander verbunden werden. Die Phase des Stroms bzw. der Spannung an dem einen Ende der λ/2-Leitung unterscheidet sich bei der Larmor-Frequenz gegenüber der Phase Strom bzw. Spannung am anderen Ende um genau 180°. Die Verbindung kann an vier gleichmäßig über den Umfang verteilten Punkten erfolgen oder an zwei um 90° gegeneinander versetzten Punkten. Dadurch wird erreicht, dass die beiden Resonatoren bei der Lamor-Frequenz parallel geschaltet werden, so dass nur noch eine einzige Resonanzfrequenz in der Nähe der Lamor-Frequenz existiert. Ein weiterer Vorteil dieser Parallelschaltung ist, dass die ungleichmäßige Bedämpfung der Resonatoren, die sich ergeben kann, wenn der Patient sich z B. dichter beim unteren Resonator befindet als beim oberen, und die Homogenität des Hochfrequenzmagnetfeldes beeinträchtigen würde, vermieden wird Beide Resonatoren werden also unabhängig von ihrer relativen Lage in bezug auf das Untersuchungsobjekt 1 gleichmäßig belastet.

Fig 3 zeigt eine Variante der Ausführungsform nach Fig 2. Dabei ist der Leiter 51 über die Abstimmkondensatoren 54 mit einem leitenden Ring 52 verbunden, der galvanisch isoliert auf einem Hochfrequenzschirm 521 aufgebracht ist. Die Stromlinien vom Leiter 51 schließen sich dann im wesentlichen über den leitenden Ring 52. Dadurch ist der Leiter 51 von dem Hochfrequenzschirm 521 entkoppelt, obwohl letzterer auch hierbei den räumlichen Verlauf des Hochfrequenzmagnetfeldes beeinflusst.
Gegenüber der Ausführungsform nach Fig 2 ergeben sich aber auch Nachteile. Die Flussdichte zwischen dem Ring 52 und der Platte 51 ist größer. Dadurch ist die Magnetische Energie im Gesamtsystem größer und die Spule unempfindlicher, oder anders ausgedrückt: der Rückstrom über 52 ist dichter an dem Nutzstrom auf der Platte 51 und mindert dadurch die Empfindlichkeit der Spule. Weiterhin sind die Verluste größer.

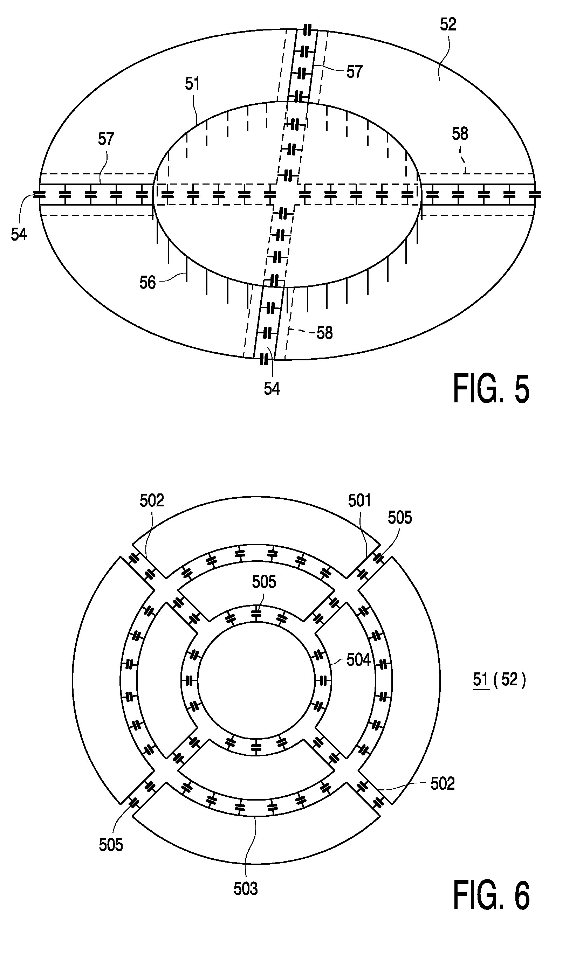

Im Sendebetrieb, d. h. wenn mit den Resonatoren 4 und 5 ein Hochfrequenzmagnetfeld erzeugt werden soll, können an den Abstimmkondensatoren 54 Wechselspannungen von einigen kV auftreten. In der Nähe der Kondensatoren ergibt sich daher ein starkes elektrisches Hochfrequenzfeld, das in der Umgebung befindliche Körperteile des Patienten 1 erwärmen kann. Diese unerwünschte Erwärmung lässt sich mit der Ausführungsform nach Fig 5 vermeiden, die auf der Erkenntnis beruht, dass die Abstimmkondensatoren nicht notwendigerweise zwischen den beiden Leitern (insbesondere an deren äußeren Rand) angeordnet sein müssen, sondern auch z B. in einem der beiden Leiter. Dementsprechend ist der Außenrand des Leiters 51 mit dem Außenrand des Leiters 52 in den Verbindungspunkten über Drähte oder leitende Streifen 56 mit diesem Leiter 52 verbunden, und in dem vom Untersuchungsbereich abgewandten Leiter 52 sind zwei radial und senkrecht zueinander verlaufende Schlitze 57 von wenigen mm Breite vorgesehen, die durch eine Anzahl von Abstimmkondensatoren überbrückt werden.

Die im äußeren Randbereich vorgesehenen Abstimmkondensatoren sind zwar immer noch relativ leicht von außen zugänglich, doch ist dies unbedenklich, weil der Abstand zum Patienten 1 in diesem Bereich relativ groß ist. Überdies ist bei gleicher Kapazität der Spannungsabfall an den Abstimmkondensatoren in diesem Bereich kleiner. Die maximalen elektrischen Feldstärken treten daher in dem unterhalb des Leiters 51 liegenden zentral Bereich des Leiters 52 auf. Der Untersuchungsbereich ist gegenüber diesen hohen elektrischen Feldstärken durch den Leiter 51 perfekt abgeschirmt.

Durch die Schlitze 57 kann das elektrische Feld jedoch mit den dahinter befindlichen Gradienten-Spulen 7 hindurch in Wechselwirkung treten und Energie in die Gradienten-Spulen einkoppeln. Dieser unerwünschte Effekt lässt sich dadurch beseitigen, dass die Schlitze 57 durch unmittelbar dahinter befindliche, in Fig. 5 gestrichelt angedeutete, leitende Streifen 58 abgedeckt und damit abgeschirmt werden. Die leitenden Streifen sind nicht mit dem Leiter 52 verbunden. Ihre Funktion könnte auch durch eine kreisförmige leitende Folie übernommen werden, die die Schlitze abdeckt.

Wenn mit dem Gradienten-Spulensystem 6 und 7 kurzzeitig magnetische Gradientenfelder ein- und wieder ausgeschaltet werden, werden in den großflächigen Leitern der Resonatoren 51 und 52 Wirbelströme induziert, die diese Leiter erwärmen und die den zeitlichen und räumlichen Verlauf der magnetischen Gradientenfelder in unerwünschter Weise beeinflussen können.

Diese Wirbelströme lassen sich verringern, wenn die beiden Leiter 51 und 52 durch Schlitze in eine Anzahl von Bereichen unterteilt sind, die eine vergleichsweise kleine Fläche haben, so dass darin nur vergleichsweise niedrige Wirbelströme induziert werden. Eine derartige Ausführungsform ist in Fig. 6 dargestellt. Danach sind in dem Leiter 51 (und ebenso im Leiter 52) zu den in Fig. 6 nicht näher dargestellten Anschlusspunkten symmetrisch angeordnete radiale Schlitze 501 und 502 sowie ringförmige Schlitze 503 und 504 vorgesehen, die ― anders als in Fig. 6 der Deutlichkeit halber dargestellt ― eine verhältnismäßig geringe Breite haben (z B. 1 mm).

Alle Schlitze sind durch Überbrückungskondensatoren 505 überbrückt. Die Kapazität der Überbrückungskondensatoren ist groß im Vergleich zu der Kapazität der Abstimmkondensatoren. Sie ist so bemessen, dass die Überbrückungskondensatoren für die Larmor-Frequenz praktisch einen Kurzschluss darstellen, während sie in dem Frequenzbereich, in dem sich das Ein- und Ausschalten des magnetischen Gradientenfeldes vollzieht (einige kHz), eine sehr hohe Impedanz aufweisen. Für die Marmor-Frequenz wirkt der so ausgebildete Leiter 51 daher wie eine einzige leitende Fläche, während er für die Frequenz der magnetischen Gradientenfelder in einer Anzahl von getrennten Bereichen unterteilt ist.

Die durch die Schlitze voneinander getrennten Bereiche sollten an möglichst vielen Stellen durch einen Überbrückungskondensator 505 miteinander verbunden sein, damit der Stromdichteverlauf bei der Larmor-Frequenz in dem Leiter weitgehend demjenigen entspricht, der sich ergeben würde, wenn die Schlitze nicht vorhanden wären. Trotz der Schlitze wirken die Leiter bei dieser Frequenz also praktisch wie ein durchgehender, großflächiger Leiter.

Je mehr Schlitze in dem Leiter 51 bzw. 52 vorhanden sind, desto besser werden die Wirbelströme unterdrückt. Mit der Zahl der Schlitze steigt aber auch die Zahl der Kondensatoren, die der Strom von einem Anschluss zu einem der (in Fig. 6 nicht näher dargestellten) Verbindungspunkte durchfließt. Da die Überbrückungskondensatoren Verluste verursachen, verringert sich damit die Güte der Resonatoren.

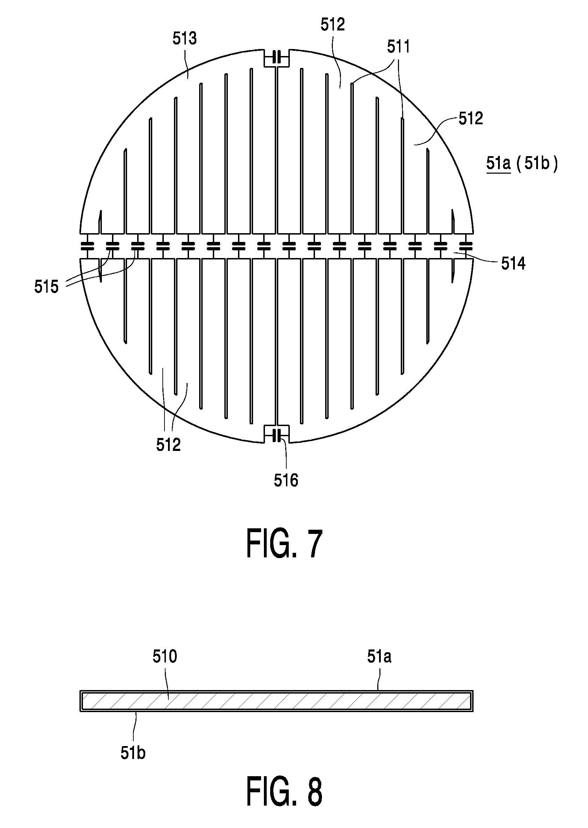

In den Fig 7 und 8 ist eine Ausführungsform, in der Draufsicht und im Querschnitt dargestellt, bei der die Wirbelströme ebenfalls wirksam unterdrückt werden können, bei der jedoch die Verluste gering bleiben, weil der Strom hierbei nur jeweils über einen Überbrückungskondensator fließt. Die Schlitze 511 in einer Leiterfläche 51a verlaufen hierbei im Idealfall tangential zu den Stromlinien in der (ungsschlitzten) Leiterplatte. Einfacher herzustellen ist aber eine Leiterfläche, die ― wie in Fig 7 dargestellt ― nur ca. 1 mm breiten Schlitze 511 in einer Anzahl paralleler Streifen 512 von etwa 2 cm Breite unterteilen, wobei außen ein ebenfalls etwa 2 cm breiter Rand 513 verbleibt.

Die Streifen 512 sind in der Mitte durch einen zusätzlichen Schlitz 514 unterbrochen und an der Unterbrechungsstelle durch je einen Überbrückungskondensator 515 überbrückt. Außerdem ist der Rand 513 an einigen Stellen unterbrochen und durch einen Kondensator 516 überbrückt. Ohne diese Unterbrechung würde der äußere Rand 513 für die magnetischen Gradientenfelder wie ein großer ringförmiger Leiter wirken, in dem das zeitlich veränderliche Gradientenmagnetfeld starke Ströme hervorrufen würde. Die Kondensatoren 514 und 516 sind wiederum so bemessen, dass ihre Impedanz bei der Larmor-Frequenz vernachlässigbar klein und im Frequenzbereich des magnetischen Gradientenfeldes sehr groß ist.

Bei dieser Gestaltung des Leiteis ist ein Stromfluss nur in der durch die Schlitze vorgegebenen Richtungen über die Überbrückungskondensatoren möglich. Mit dieser Anordnung allein kann also kein zirkular polarisiertes Magnetfeld erzeugt werden. Zu diesem Zweck muss noch ein zweiter identisch aufgebauter Leiter vorhanden sein, dessen Schlitzmuster gegenüber dem in Fig. 7 dargestellten um 90° gedreht ist. Dies ist in Fig. 8 angedeutet, bei der auf der einen Seite eines isolierenden Trägerkörpers eine Leiterfläche 51a mit einem Schlitzmuster gemäß Fig. 7 und auf der anderen Seite eine identisch aufgebauter Leiterfläche 51b vorgesehen ist, deren Schlitzmuster relativ zu dem der Leiterfläche 51a um 90° gedreht ist. Am einfachsten lässt sich dies durch eine beidseitig mit einem leitenden Schlitzmuster versehene Leiterplatte realisieren.

Die beiden äußeren Ränder 513 der Leiterflächen 51a und 51b sind miteinander verbunden. Sie können in gleicher Weise mit Verbindungspunkten versehen sein, wie in Verbindung mit Fig. 2 erläutert. Beide Polarisationsrichtungen benutzen also auch dabei die Abstimmkondensatoren gemeinsam. Bei geeigneter Lage der Anschlüsse verhalten sich die beiden Leiterflächen 51a und 51b zusammen bei Hochfrequenz kaum anders als ein einziger großflächiger und durchgehender (nicht durch Schlitze unterbrochener) Leiter mit entsprechend angeordneten Verbindungspunkten und Anschlüssen. Es ist auch möglich mehr als zwei leitende Flächen auf diese Weise miteinander zu verbinden, z B. vier, die dann um 45° verdreht übereinander liegen.
Der Hochfrequenzschirm 52 kann auf analoge Weise aufgebaut sein.

Die Erfindung wurde vorstehend in Verbindung mit der Erzeugung von Hochfrequenzmagnetfeldern (Sendebetrieb) erläutert, doch kann die erfindungsgemäße Quadratur-Spulenanordnung auch zum Empfang von MR-Signalen mit um 90° gegeneinander versetzter Phasenlags benutzt werden. Grundsätzlich könnte die Quadraturspule auch nur einen Resonator, den oberen oder unteren, enthalten. Allerdings müsste dieser dann verhältnismäßig groß sein (und der Untersuchungsbereich in z-Richtung verhältnismäßig klein), wenn damit im Untersuchungsbereich ein hinreichend homogenes Magnetfeld erzeugt werden soll.

## Patentansprüche

1. MR-Gerät mit einem offenen Magnetsystem (2, 3) zur Erzeugung eines homogsnen stationären Magnetfeldes in einem Untersuchungsbereich (1) und mit einer Quadratur-Spulenanordnung (4, 5), die auf mindestens einer der beiden in Richtung des stationären Magnetfeldes versetzten Seiten des Untersuchungsbereichs einen durch Abstimmkapazitäten (54) abgestimmten Resonator mit folgenden Merkmalen enthält:
- der Resonator umfasst auf seiner dem Untersuchungsbereich zugswandten Seite einen ersten großflächigen Leiter (51) und auf seiner vom Untersuchungsbereich abgewandten Seite einen zweiten im Abstand von dem ersten befindlichen zweiten Leiter (52),
- die beiden Leiter sind ― zumindest bei der Frequenz, bei der der Resonator in Resonanz ist ― elektrisch miteinander verbunden
- der Resonator ist mit wenigstens zwei auf dem Umfang verteilten Anschlüssen (56) zum Empfangen oder Erzeugen von in der Phase gegeneinander versetzten Hochfrequenzmagnetfeldern versehen

2. MR-Gerät nach Anspruch 1, wobei der zweite Leiter (52) ebenfalls großflächig ist und größere Abmessungen aufweist als der erste Leiter und dadurch als Hochfrequenzschirm wirksam ist.

3. MR-Gerät nach Anspruch 1, wobei der zweite Leiter (52) sich zwischen dem ersten Leiter (51) und einem Hochfrequenzschirm befindet, wobei der zweite Leiter (52) gegenüber dem Hochfrequenzschirm isoliert ist und sein Abstand von diesem wesentlich kleiner ist als sein Abstand vom ersten Leiter.

4. MR-Gerät nach Anspruch 1, wobei der erste Leiter (51) eine Kreisform oder die Form eines regelmäßigen Polygons hat und an einer Vielzahl von gleichmäßig über seinen Umfang verteilten Verbindungspunkten (53) mit dem zweiten Leiter elektrisch verbunden ist, und wobei die Verbindungspunkte und die Anschlüsse (56) zueinander so versetzt angeordnet sind, dass sich für jeden Anschluss dieselbe Konfiguration ergibt.

5. MR-Gerät nach Anspruch 4, wobei die beiden Leiter (51, 52) des Resonators an den Verbindungspunkten (53) über Abstimmkondensatoren (54) miteinander verbunden sind.

6. MR-Gerät nach Anspruch 1, wobei zwischen beiden Leitern (51, 52) des Resonators ein Dielektrikum vorgesehen ist.

7. MR-Gerät nach Anspruch 5, wobei der zweite Leiter (52) durch Schlitze (57) unterteilt ist, die durch Abstimmkapazitäten (54) überbrückt sind, und wobei die beiden Leiter an den Verbindungspunkten niederohmig leitend verbunden sind.

8. MR Gerät nach Anspruch 1, wobei die Leiter (51, 52) mit Schlitzen (501, 502....504) versehen sind, von den wenigstens ein Teil durch Überbrückungskondensatoren (505) überbrückt ist.

9. Gerät nach Anspruch 1, wobei wenigstens einer der beiden Leiter (51) zwei an ihrem Außenrand zumindest bei Hochfrequenz leitend miteinander verbundene leitende Flächen (51a, 51b) enthält, die durch Schlitze (511) in eine Anzahl von schmalen Streifen (512) unterteilt sind, von denen jeder an mindestens einer Stelle durch einen von einem Überbrückungskondensator (515) überbrückten Schlitz (514) unterbrochen ist, und wobei die von den Schlitzen gebildeten Schlitzmuster der beiden leitenden Flächen gegeneinander verdreht sind.

10. MR-Gerät nach Anspruch 9, wobei der Leiter eine beidseitig mit einem Schlitzmuster (51a, 51b) versehene Leiterplatte (510) umfasst.

11. MR-Gerät nach Anspruch 1 mit zwei Resonatoren (4, 5), von denen der eine mit dem anderen über eine Leitung (8) der Länge nλ/2 verbunden ist, wobei λ die Wellenlänge in der Leitung bei der Betriebsfrequenz des Resonators ist und n eine positive ganze Zahl > 0 ist.

12. MR-Gerät nach Anspruch 1, wobei wenigstens einer der Leiter (52) mit Schlitzen versehen ist, die auf der vom Untersuchungsbereich abgsvwidten Seite durch Leiterstreifen (58) abgsdeckt sind

13. Quadratur-Spulenanordnung für ein MR-Gerät mit einem offenen Magnetsystem zur Erzeugung eines homogenen stationären Magnetfeldes in einem Untersuchungsbereich, die mindestens einen durch Abstimmkondensatoren (54) abgestimmten Resonator (4,5) mit folgenden Merkmalen enthält:
- der Resonator umfasst auf seiner einen Seite einen ersten großflächigen Leiter (51) und auf seiner vom Untersuchungsbereich anderen Seite einen zweiten im Abstand von dem ersten befindlichen zweiten Leiter (52),
- die beiden Leiter sind ― zumindest bei der Frequenz, bei der der Resonator in Resonanz ist ― elektrisch miteinander verbunden
der Resonator ist mit wenigstens zwei auf dem Umfang verteilten Anschlüssen (56) zum Empfangen oder Erzeugen von in der Phase gegeneinander versetzten Hochfrequenzmagnetfeldern versehen.
